# EUROPÄISCHE PATENTSCHRIFT

(11) **EP 0 607 180 B1**
(45) Veröffentlichungstag und Bekanntmachung des Hinweises auf die Patenterteilung: **03.07.1996**
(21) Anmeldenummer: 92919626.9
(22) Anmeldetag: 17.09.1992
(51) Int. Cl.: H01L 21/18, H01L 21/78

(54) **VERFAHREN ZUR HERSTELLUNG VON HALBLEITERBAUELEMENTEN**
PROCESS FOR MANUFACTURING SEMICONDUCTOR COMPONENTS
PROCEDE DE FABRICATION DE COMPOSANTS SEMI-CONDUCTEURS

(30) Priorität: 12.10.1991 DE 4133820
(43) Veröffentlichungstag der Anmeldung: 27.07.1994
(73) Patentinhaber: ROBERT BOSCH GMBH, 70442 Stuttgart (DE)
(72) Erfinder: SPITZ, Richard, D-7410 Reutlingen 17 (DE); GOEBEL, Herbert, D-7410 Reutlingen 17 (DE); BIALLAS, Vesna, D-7410 Reutlingen 23 (DE)
(86) Internationale Anmeldenummer: DE9200792
(87) Internationale Veröffentlichungsnummer: WO9308592

(56) Entgegenhaltungen:
- EP-A- 0 269 294
- EP-A- 0 341 075
- WO-A-92/09099
- DE-B- 1 514 363
- US-A- 3 852 876
- US-A- 4 179 794

## Beschreibung

### Stand der Technik

Die Erfindung betrifft ein Verfahren zur Herstellung von Halbleiterbauelementen, insbesondere Dioden.

Aus der DE-OS 38 15 615 ist ein Verfahren zur Herstellung einer hochsperrenden Leistungsdiode bekannt, bei dem die Dotierung des Halbleitermaterials durch Diffusion erfolgt. Ein Halbleiterkörper wird an seinen beiden Hauptoberflächen mit Bor beziehungsweise mit Phosphor belegt und dann werden diese beiden Dotierungssubstanzen in einem ersten Diffusionsschritt durch Erwärmen des so belegten Halbleiterkörpers auf eine bestimmte Diffusionstemperatur gebracht, bis eine bestimmte Diffusionstiefe vorliegt. Es ist ferner bekannt, zum Aufbringen der Dotierstoffe Dotierfolien zu verwenden, die auf den Halbleiterkörper aufgelegt werden. Geeignete Bedingungen für den ersten Diffusionsschritt sind eine Diffusionstemperatur von zum Beispiel 1200 °C und eine Diffusionszeit von 30 Stunden unter oxidierender Atmosphare. An diesen Diffusionsprozess schließt sich ein Getterprozeß an, der für eine ausreichend hohe Ladungsträgerlebensdauer sorgt. Anschließend werden auf die beiden freiliegenden Oberflächen des Halbleiterkorpers dünne Metallschichten aufgebracht, wobei sich die Art der Metallschichten nach dem Einsatzgebiet richtet. Für Lötvorgänge ist zum Beispiel die Schichtfolge Al/Ni (Aluminium/Nickel) oder Cr/Ni/Ag (Chrom/Nickel/Silber) geeignet. Anschließend wird der Halbleiterkörper durch Sägen oder andere Trennverfahren in einzelne Chips unterteilt. Nach der Zerteilung werden die einzelnen Chips zwischen jeweils zwei Anschlüsse gelötet, die vorzugsweise aus Kupfer bestehen. Nach diesem Lötvorgang sind beide Chip-Stirnflächen durch das Lot und die Anschlüsse vollständig abgedeckt. Der beim Zersägen seitlich freigelegte und durch den Sägevorgang beschädigte pn-Übergang wird anschließend zum Beispiel naßchemisch in heißer Kalilauge oder im Plasma geätzt, um die Beschädigungen abzutragen. Aufgrund der Abdeckung der Chip-Stirnflächen durch das Lot und die Anschlüsse sind diese während des Ätzvorgangs gegen Abtragung geschützt. Anschließend kann die fertige Leistungsdiode zum Beispiel mit Kunststoff umhüllt werden, so daß sie passiviert und gegenüber Umgebungseinflüssen geschützt ist. Erst wenn so die fertig montierte und verpackte Leistungsdiode fertiggestellt ist, kann sie elektrisch gemessen und damit geprüft werden.

Für die Herstellung von Zener-Dioden sind folgende Verfahren bekannt:

Bei Mesa-Dioden wird ein Herstellungsverfahren mit Epitaxie- und Fotolithographie-Schritten angewendet. Ferner werden V-förmige Gräben geätzt, wobei die gesamte Herstellung unter Reinraumbedingungen durchgeführt wird. Die Einhaltung der Reinraumbedingungen führt zu relativ hohen Kosten. Zur Herstellung von Schottky-Dioden werden ebenfalls Fotolithographie-Schritte und Reinraumbedingungen benötigt. Kritisch für eine Serienfertigung ist auch der Kontakt zwischen Metall und Silicium (Si), da dieser einen sehr gut definierten Zustand der Si-Oberfläche bedingt. Schottky-Dioden weisen relativ hohe Sperrströme auf und sind nicht impulsfest.

Schließlich ist es bei der Herstellung von Planar-Dioden ebenfalls bekannt, daß Epitaxie-Schichten sowie Fotolithographie-Schritte unter Reinraumbedingungen notwendig sind.

Bei bekannten Verfahren zur Herstellung hochsperrender Dioden werden zunächst im Diffusionsverfahren die gewünschten Dotierungen erzeugt und anschließend beide Waferseiten zum Beispiel mit Ni/Au (Nickel/Gold) metallisiert. Anschließend werden beide Seiten zum Schutz der Metallisierung gegenüber den weiteren nachfolgenden Verfahrensschritten, mit Lack versehen. Anschließend wird ein Raster gesägt, wobei die Trennschnitte aufgrund einer speziellen Säge V-Form erhalten. Es folgt dann eine Saure-Ätzung innerhalb der Gräben. Schließlich wird zum Passivieren eine Auffüllung der Gräben mit Polyimid-Lack mittels einer Rakel vorgenommen. Anschließend wird der Lack auf der Metallisierung durch Plasmastripper entfernt. Letztlich erfolgt dann noch ein Vereinzeln durch Sägen.

Aus der US 4 179 794 ist bereits ein Verfahren zur Herstellung von Halbleiterelementen bekannt, bei dem zunächst verschiedene Diffusionszonen in einen Siliziumwafer eingebracht werden. Danach erfolgt das Aufbringen und Strukturieren von jeweils einer Isolationsschicht 15 und Metallschicht 19, 18. Diese Schichten werden dann als Ätzmaske für das Einätzen von Gräben verwendet. In den Gräben wird dann ein Oxid oder Nitridfilm erzeugt, der zur Vermittlung der guten Haftung eines danach aufgebrachten Polyimidfiles dient (Spalte 4, Zeilen 6 bis 19). In einem weiteren Schritt werden dann die Siliziumwafer in einzelne Chips zerteilt.

Aus der EP 269 294 A1 und aus der DE-B-1 514 363 ist ein Verfahren zur Herstellung von mehrschichtigen Siliziumstrukturen bekannt, bei dem zwei Siliziumwafer miteinander gebondet werden.

Aus der US 3 852 876 ist ein Verfahren zur Herstellung von Halbleiterbauelementen bekannt. In einem ersten Verfahrensschritt werden verschiedene Dotierungszonen in einen Wafer eingebracht. Mit zwei Strukturierungsschritten wird dann die Oberseite teilweise mit einem Oxid und teilweise mit einem Kunststoff bedeckt. Durch einen Ätzschritt werden dann Gräben eingebracht, deren Seitenwände durch eine Glaspassivierung geschützt werden. Es wird dann eine Metallschicht aufgebracht, die in einem weiteren Strukturierungsschritt strukturiert wird. Durch Zerteilen in den Gräben werden dann die einzelnen Chips aus dem Siliziumwafer herausgelöst.

Aus der EP 341 075 A2 ist ein Verfahren zur Herstellung von Halbleiterbauelementen bekannt, bei dem durch Sägen ein Graben eingebracht wird und danach durch Überätzen des Grabens die durch das Sägen geschädigte Oberflächenschicht abgetragen wird.

Dem erfindungegemäße Verfahren liegt die Aufgabe zugrunde ein schnelleres, besseres und kostengünstigeres Verfahren zur Herstellung von Halbleiterbauelementen anzugeben. Diese Aufgabe wird durch die Merkmale des unabhängigen Anspruchs 1 gelöst.

Weiterhin hat das erfindungsgemäße Verfahren den Vorteil, daß anstelle einer Diffusion das Silicium-Verschmelzungs-Verbindungsverfahren (Silicon-Fusion-Bonding, SFB) eingesetzt wird, das deutlich niedrigere Temperaturen für wesentlich kurzere Zeiten benotigt. Ferner erfolgt die Metallisierung beim Gegenstand der Erfindung erst am Ende des Prozesses, was dazu führt, daß die pn-Übergange insbesondere auch durch thermische Oxidation passiviert werden können. Dies ist nicht mehr möglich, wenn sich bereits Metall auf dem Wafer befindet. Beim Gegenstand der Erfindung ist es im allgemeinen moglich, höhere Temperaturen für die Passivierung zuzulassen. Beim Überätzen der Gräben (pn-Übergange, besteht überdies beim Gegenstand der Erfindung nicht die Gefahr, daß Metall angegriffen wird da noch keine Metallisierung vorhanden ist. Dies könnte bei dem geschilderten, bekannten Lack-Abdeckverfahren erfolgen, wenn der Lack nicht hinreichend dicht ist oder die Lackhaftung nicht ausreicht. Erfindungsgemäß werden also zunächst mindestens zwei Halbleiterkörper unterschiedlichen Leitungstyps (p-Leitung, n-Leitung) nach dem SFB-Verfahren miteinander verbunden. Es erfolgt dann ein Separieren einer Vielzahl von Halbleiterelementen durch Erzeugung von Gräben, deren Tiefe mindestens bis zum pn-Übergang reicht. Vorzugsweise Durchdringen die Gräben einen der beiden Halbleiterkörper vollständig und setzen sich im zweiten Halbleiterkörper derart fort, daß nur ein Teilabschnitt der gesamten Dicke dieses Halbleiterkörpers von den Gräben durchsetzt wird. Durch anschließendes Passivieren der seitlich durch die Gräben freigelegten pn-Übergänge wird ein Schutz erzeugt. Dann werden die Oberflächen der Halbleiterkörper metallisiert und schließlich eine Vereinzelung der Halbleiterelemente vorgenommen. Vorzugsweise kann nach dem Passivieren, das heißt, dem Auffüllen der Graben zum Beispiel mit einem Polyimid-Lack, ein Schleifverfahren zur Einebnung der Oberflächen der Halbleiterkörper durchgeführt werden. Wäre bereits eine Metallisierung vorhanden -wie das beim Stand der Technik der Fall ist- so dürfte kein der Passivierung dienender Polyimid-Lack auf den bereits metallisierten und durch Lack geschützten Flächen verbleiben. Dies bedeutet jedoch, daß keine Möglichkeit der mechanischen Entfernung mehr besteht, das heißt, das genannte Schleifverfahren könnte beim Gegenstand des Standes der Technik nicht durchgeführt werden. Beim Gegenstand der Erfindung besteht überdies der Vorteil, daß die Lötfähigkeit der Metallisierung nicht beeinträchtigt oder gar unmöglich wird. Dies kann jedoch beim Gegenstand des Standes der Technik dadurch erfolgen, daß Polyimid-Reste verbleiben oder -wenn die Goldschicht nicht völlig dicht ist- es kann durch Plasmastrippen das Benetzungsverhalten des Nickels (Ni) beim Lötprozeß verschlechtert werden. Überdies muß bei den bekannten Diffusionsverfahren die Waferdicke möglichst gering gewählt werden, was nur eine geringe mechanische Stabilitat beim Handling zur Folge hat. Beim Gegenstand der Erfindung ist es hingegen möglich, auch Halbleiterkörper entsprechender Dicke und Stabilität einzusetzen, da nach dem SFB-Verfahren gearbeitet wird. Der Gegenstand der Erfindung verlangt nicht den Einsatz spezieller Sägen (die zum Beispiel für die Erstellung V-förmiger Gräben erforderlich sind). Es sind Standardsägen für die Separations- und Trennprozesse einsetzbar. Der Gegenstand der Erfindung verlangt auch keine aufwendigen fotolithographischen Prozeßschritte. Überdies ist für die Waferprozessierung kein Reinraum erforderlich. Der SFB-Prozeßschritt kann unter einer Laminar-Flow-Box oder einer geeigneten abgeschlossenen Apparatur durchgeführt werden. Die SFB-Technik führt gegenüber Diffusionsprozessen zu wesentlich geringeren Herstellungskosten. Beim Gegenstand der Erfindung ist es ferner möglich, Gräben mit im wesentlichen senkrechten Wandungen zu erstellen, die erheblich weniger Waferfläche als die aus dem Stand der Technik bekannten V-förmigen Gräben benötigen. Diese erfindungsgemäß nur sehr schmalen Trenngräben zwischen den einzelnen Halbleiterelementen (Chips) sparen jedoch nicht nur Silicium-Fläche, sondern sie können auch mit konventionellen Sagen und mit hoher Schnittgeschwindigkeit angelegt werden. Ferner sind sie sehr einfach mit Lacken, wie zum Beispiel Polyimiden, wieder auffüllbar, um eine plane Oberfläche für die nachfolgende Metallisierung zu schaffen. Vorteilhaft sind Grabenbreiten zwischen 100µm bis 150µm nach Durchführung des Ätzprozesses. Ferner ist es vorteilhaft, wenn bei den Wafern eine <111>-Orientierung vorgesehen wird, da die Waferoberflächen relativ zu den vorzugsweise gesagten Gräben in Kalilauge nur extrem schwach angeätzt (gedünnt) werden. Es kann daher auf eine teure Oberflächenmaskierung des Wafers während des Überätzens der Gräben in Lauge verzichtet werden. Da durch die SFB-Methode an den pn-Übergängen bereits eine hohe Borkonzentration zu finden ist (zum Beispiel > 10¹⁹cm⁻³) wird der Ätzprozeß dort automatisch gestoppt. Durch die freie Wahl der Dicke der Wafer, zum Beispiel des p⁺-Wafers, kann -wie bereits erwähnt- eine ausreichende mechanische Stabilität für das Waferhandling auch für größere Waferdurchmesser als zum Beispiel 100mm gewährleistet werden. Dies wird erfindungsgemäß nicht durch drastisch verlängerte Diffusionszeiten erkauft. Ferner kann die relativ große Dicke zum Beispiel des p⁺-Wafers als Wärmepuffer für Leistungsdioden (insbesondere im Impulsbetrieb) genutzt werden. Durch die "wählbare" mechanische Stabilität des Wafersystems ist es auch möglich, die Metallisierung in einem Simultan-Sputter-Durchlaufverfahren durchzuführen. Beide Seiten des Waferstystems werden simultan in einer Schichtfolge beschichtet, wobei aufgrund des Durchlaufverfahrens mit einer Durchlaufanlage vollautomatisch gearbeitet werden kann. Das genannte Sputter-Metallisierungsverfahren ist mit speziellen Metallen und Metallfolgen -wie beim Gegenstand der Erfindung vorliegend- gerade auf nicht polierten Si-Oberflächen, also auch auf den beim erfindungsgemäßen Herstellungsverfahren geschliffenen Si-Oberflächen bestens geeignet. Besonders vorteilhaft ist es, daß aufgrund der Erfindung die einzelnen Chips bereits nach dem Vereinzeln (Sägen oder andere Trennverfahren) elektrisch gemessen werden können, da die Chips schon in diesem Zustand passiviert sind. Derartig passivierte Chips können auch ohne Einzelmontage und -Verpackung (wie das im Gegensatz dazu beim Stand der Technik notwendig ist) direkt in einen geeigneten Kühlkörper eingelötet werden. Das erfindungsgemäße Herstellungsverfahren eignet sich sowohl für die Erstellung von hochsperrenden Lestungsdioden als auch von Zenerleistungsdioden. Besonders rationell kann gearbeitet werden, da Wafer mit großen Durchmessern, zum Beispiel von 150mm einsetzbar sind, ohne daß langer dauernde Diffusionsschritte auftreten.

Nach einer Weiterbildung der Erfindung wird das Silicium-Verschmelzungs-Verbindungsverfahren vorzugsweise bei Temperaturen über 1000°C für mehr als eine Stunde, insbesondere bei 1080°C für zwei Stunden unter Stickstoffatmosphäre, durchgeführt. Die Separation der einzelnen Halbleiterelemente (Chips) durch das Einbringen von Gräben erfolgt vorzugsweise durch Einsägen. Wie bereits erwähnt, wird die Tiefe der Sageschnitte derart gewählt, daß der eine Wafer vollständig und der andere Wafer teilweise zersägt beziehungsweise eingesagt wird. Die Atzung zum Abtragen der durch den Sägevorgang erfolgten Beschädigung der pn-Übergange wird bevorzugt naßchemisch, insbesondere mit heißer Kalilauge, durchgeführt.

Für das Passivieren sind verschiedene Varianten durchführbar: Das Passivieren kann mit in die Gräben eingebrachten Polyesterimid-Lack oder dergleichen erfolgen. Dieser Lack kann mit Wasser verdünnt werden. Das Passivieren ist auch durch thermisches Oxidieren, insbesondere bei über 1000°C, und anschließendes Einbringen von Lack, insbesondere Polyesterimid-Lack, möglich. Das Passivieren ist auch durch Abscheidung einer Substanz, insbesondere mittels eines pyrolytischen Abscheideverfahrens, vorzugsweise durch Abscheiden von Silicium-Nitrid, möglich. Schließlich kann das Passivieren auch durch Einbringen von Polyimid-Lack in die Gräben erfolgen.

Nachdem vor dem Metallisieren die Oberfläche des aus den beiden Wafern gebildeten Wafersystems durch einen mechanischen Schleifprozeß derart abgetragen wurde, daß nur noch das reine Wafermaterial vorhanden ist, wird Metall auf die Oberfläche aufgedampft und/oder aufgesputtert. Wie erwähnt, werden vorzugsweise die Oberflächen beider Wafer gleichzeitig metallisiert.

Beim anschließenden Vereinzeln der Chips durch Heraustrennen aus dem Wafersystem werden die erforderlichen Trennfugen innerhalb der durch Passivieren gefüllten Gräben derart ausgebildet, daß sie beide Wafer vollständig durchsetzen und Passivierungsmaterial zum Abdecken der Seitenflanken der Halbleiterelemente (zum Schutze der pn-Übergänge) stehen bleibt. Diese Trennfugen werden vorzugsweise durch Zersägen des Wafersystems erstellt. Sie haben parallel verlaufende Schnittkanten und benötigen daher nur wenig Raum.

### Zeichnung

Die Erfindung wird im folgenden anhand der Figuren näher erläutert. Es zeigen:
- Figur 1: Abschnitte zweier Wafer, die miteinander zu verbinden sind,
- Figur 2: die nach dem Silicium-Verschmelzungs-Verbindungsverfahren (SFB) zusammengefügten Wafer gemäß 1,
- Figur 3: in das Wafersystem eingebrachte Graben zur Separation einer Vielzahl von Halbleiterelementen (Chips),
- Figur 4: Verbreiterung der Gräben durch ein Ätzverfahren,
- Figur 5: Passivierung der durch die Gräben freigelegten pn-übergänge durch Einbringen eines Lacks,
- Figur 6: das Wafersystem mit durch mechanisches Schleifen eingeebneter Oberfläche,
- Figur 7: das Wafersystem mit auf die Oberflächen aufgebrachter Metallisierung,
- Figur 8: das Wafersystem mit Trennschnitten zum Heraustrennen der einzelnen Halbleiterelemente und
- Figur 9: ein Diagramm, das bei einer nach dem erfindungsgemäßen Verfahren hergestellten Diode den Einfluß der p⁺-Dicke auf die Flußspannung zeigt.

### Beschreibung eines Ausführungsbeispiels

Anhand der Figuren wird nachfolgend das Verfahren zur Herstellung von Halbleiterbauelementen, nämlich am Beispiel einer hochsperrenden PIN-Leistungsdiode, erläutert. Ausgangsmaterial sind zwei Wafer 1 und 2 aus Silicium, die eine Orientierung <111> aufweisen. Bei dem Wafer 1 handelt es sich um einen sogenannten n-Typ mit einer Gesamtdicke von 245µm. Er weist eine Schicht 3 mit einer Dicke von 170µm auf, wobei die Dotierung n > 1 · 10²⁰cm⁻³ (n⁺-Typ; Phosphor) ist. Ferner ist eine Schicht 4 mit einer Dicke von 75µm mit n = 7 · 10¹³ cm⁻³ vorgesehen. Beim Wafer 1 handelt es sich somit um einen sogenannten Rückseiten-diffundierten Wafer.

Der Wafer 2 ist homogen dotiert, er weist eine Dicke von 350µm auf und ist ein p-Typ mit p = 8 · 10¹⁹cm ⁻³ (Bor). Die Oberflächen 5 und 6 der Wafer 1 und 2 sind poliert.

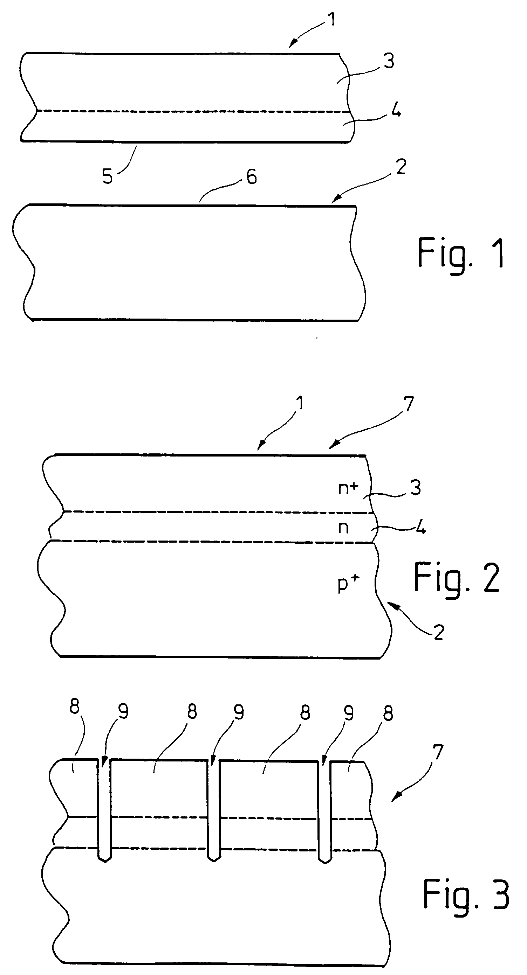

Die Wafer 1 und 2 werden einer RCA-Reinigung unterzogen, bevor sie miteinander verbunden werden. Das Verbinden erfolgt in partikelfreier Atmosphäre (Laminar-Flow-Box oder entsprechender Apparatur) mit einer Temperaturbehandlung von 1080°C, zwei Stunden in N₂-Atmosphäre nach dem Silicium-Fusion-Bonding (SFB, Silicium-Verschmelzungs-Verbindungsverfahren). Die miteinander verbundenen Wafer 1 und 2 sind in der Figur 2 als nunmehr entstandenes Wafersystem 7 dargestellt.

Der Wafer 2 (p⁺-Wafer) kann -ebenso wie der wafer 1- einen Durchmesser von zum Beispiel 150mm haben. Gegenüber der vorstehenden Angabe kann er auch dünner gewählt werden, wenn er zum Beispiel lediglich einen Durchmesser von 100mm aufweist. Eine Dicke von zum Beispiel 250µm wäre dann ausreichend. Der Wafer 2 sorgt für eine mechanische Stabilität beim Handling des Wafersystems 7.

Gemäß Figur 3 wird das Wafersystem 7 in eine Vielzahl von Halbleiterelementen (Chips 8) durch Erzeugung von Gräben 9 separiert. Dies erfolgt mit einer üblichen Si-Säge mit Diamantsageblatt. Das durch das Sägen gebildete Raster wird entsprechend der gewünschten Diodenfläche, zum Beispiel 3,8mm X 3,8mm in Kantenlänge, gewählt. Die Tiefe des Sägeschnittes beträgt im dargestellten Ausführungsbeispiel ca. 260µm; sie ist so tief, daß in den unteren p⁺-Wafer 2 mit eingesagt wird. Mithin werden die pn-Übergänge freigelegt. Die Breite der Graben beträgt ca. 30µm bis 35µm.

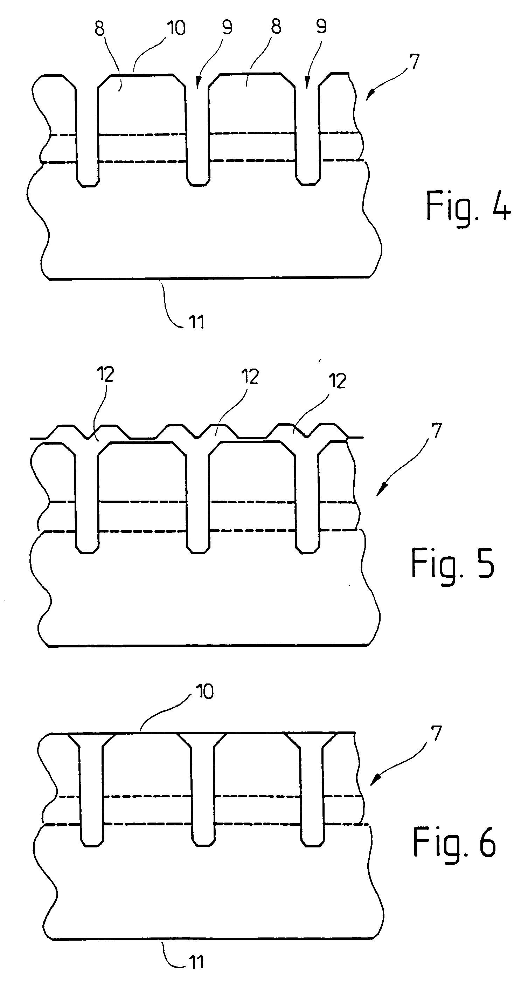

Im nachfolgenden Verfahrensschritt (Figur 4) werden die durch das Sägen seitlich freigelegten und dabei beschädigten pn-Ubergange naßchemisch, insbesondere in heißer Kalilauge (zum Beispiel 30% KOH bei 80°C, 25 Min.) geätzt, um die Beschädigungen abzutragen. Dies führt zu einem seitlichen Abtrag von ca. 30µm. Durch das Entfernen eines seitlichen Bereichs von ca. 30µm sind alle Beschädigungen mit Sicherheit beseitigt, so daß die entstehende Diode später dann auch bei hohen Sperrspannungen (zum Beispiel 750V) nur kleine Leckstrome aufweist. Die Kalilauge ätzt die <111>-Flächen relativ zu allen anderen Orientierungen am langsamsten, so daß beim seitlichen Abtragen der Graben 9 die Oberflächen 10 und 11 des Wafersystems 7 so gut wie nicht abgetragen werden. Besteht eine Oberflächenrauhigkeit (geläppte Flächen) so wird diese durch das Ätzen etwas eingeebnet. Beim Durchführen des Verfahrens mit einem seitlichen Ätzabtrag in den Gräben 9 von ca. 30µm werden die gelappten Oberflächen 10 und 11 des Wafersystems lediglich um ca. 5µm abgetragen, so daß die Gesamtdicke des Wafersystems 7 lediglich um 10µm abnimmt.

Nunmehr erfolgt ein Passivieren der durch die Gräben 9 freigelegten pn-Übergänge und Auffüllen der entstandenen Graben 9. Dies ist auf verschiedene Arten möglich:
a) Das Auffüllen der Gräben 9 erfolgt mit Polyesterimid-Lack 12. Dieser Lack wird mit Wasser verdünnt, so daß seine Eigenschaften dem Verfahren sehr gut anpaßbar sind. Sofern eine Polyesterimid-Lackschicht aufgebracht wird, so sollte diese sehr dünn, vorzugsweise zwischen 5µm und 15µm sein, um eine Blasenbildung beim Aushärten zu vermeiden. Der Lack wird vorzugsweise auf die waagerecht mit den Gräben nach oben liegenden, verbundenen Wafer 1,2 aufgetropft und mit einer Rakel in die Gräben 9 verteilt. Wenn die Tiefe der Gräben 9 im Verhältnis zur Breite bei etwa 3:1 oder mehr liegt, werden die Gräben 9 durch Kapillarwirkung sehr homogen aufgefüllt. Dies wird unterstützt durch eine niedrige Viskosität und geeignete Oberflächenspannung des Lacks. Beides wird durch die Auswahl der Lösemittel gesteuert. Besonders vorteilhaft ist eine Mischung aus Wasser und N-Methylpyrrolidon (NMP) im folgenden Verhältnis:
   Polyesterimid 10% bis 20%, insbesondere 17%
   Wasser 40% bis 50%, insbesondere 50%
   NMP 30% bis 40%, insbesondere 33%.
   Die Wafer 1, 2 werden für diesen Prozeßschritt vorzugsweise auf 70° C erwärmt. Durch die Kapillarwirkung in den Gräben 9 verteilt sich dort der Lack gleichmäßig, wobei die überätzten Bereiche sehr gut benetzt werden. Anschließend werden Wasser und Lösungsmittel durch einstündige Temperaturbehandlung bei vorzugsweise 120°C ausgetrieben. Dies erfolgt vorzugsweise in Kontakt mit der Luftatmosphäre. Ist dieser Verfahrensschritt durchgeführt, so sind die pn-Übergänge passiviert. Um zusätzlich (wegen der nachfolgenden Metallisierung) die Gräben 9 auch noch vollständig aufzufüllen (einzuebnen), wird der beschriebene Vorgang des Auftragens und Trocknens von Polyesterimid-Lack mindestens noch einmal, nötigenfalls noch zweimal wiederholt. Anschließend erfolgt dann ein Aushärten bei vorzugsweise 260°C für vier Stunden.
b) Das Passivieren kann auch durch thermisches Oxidieren und Auffüllen der Gräben 9 durch Lack, insbesondere Polyesterimid-Lack, erfolgen. Da in diesem Verfahrensstadium noch keine Metallisierung aufgebracht ist, kann ein Hochtemperaturprozeß, wie ihn die thermische Oxidation darstellt, durchgeführt werden. Vorzugsweise erfolgt dieser Prozeß bei 1000°C bis 1100°C, wobei sich eine Oxydschicht von etwa 1µm bis 1,3µm bildet. Anschließend wird ein- bis zweimal der vorstehend beschriebene Polyesterimid-Lack-Aufbringschritt zur Einebnung durchgeführt.
c) Das Passivieren kann ferner durch ein CVD-Nitrid (Si₃N₄-Schicht durch ein pyrolytisches Abscheideverfahren) erfolgen. Silicium-Nitrid ist als besonders gute Sperre gegen Na (Natrium) bekannt. Zum Auffüllen der Gräben nach dieser durchgeführten Passivierung ist dann wieder zum Beispiel das Auftragen von Polyesterimid-Lack vorgesehen.
d) Schließlich kann das Passivieren und Planarisieren auch mit Polyimid-Lack erfolgen. Dieser Lack wird auf das Wafersystem 7 aufgebracht und mit einer Rakel verteilt, wobei es in die Gräben 9 gestrichen wird. Anschließend erfolgt ein Aushärten bei mindestens 260°C. Prinzipiell kann mit dem Polyimid-Lack ebenso vorgegangen werden wie unter Punkt b) und c).

Nach dem Passivieren und Planarisieren liegt der Zustand gemäß Figur 5 vor. Nunmehr wird -gemäß Figur 6- die Oberfläche 10 des Wafersystems 7 durch einen mechanischen Schleifprozeß eingeebnet und soweit abgetragen, daß das Si-Material vollständig wieder frei liegt. Vorzugsweise erfolgt ein dreistufiger Prozeß mit einer automatischen Schleifmaschine, bei dem die Oberfläche 10 von Stufe zu Stufe glatter wird und zum Abschluß ein Reinigungsschritt (mit DI-Wasser und "Bürste") erfolgt. Wurde zur Passivierung eine thermische Oxydation durchgeführt (wie vorstehend beschrieben), dann wird auch die Oberfläche 11 des Wafersystems 7 geschliffen, so daß auch dort die Si-Oberfläche wieder vollständig freiliegt.

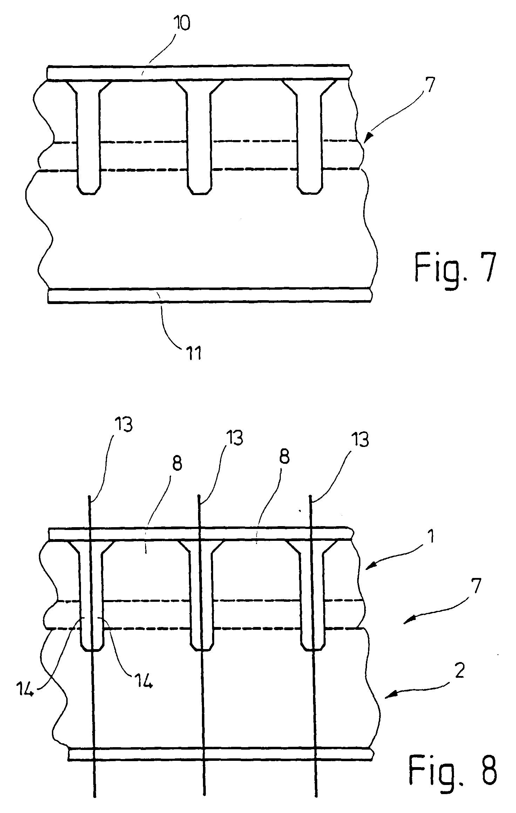

Im nachfolgenden Herstellungsschritt wird -gemäß Figur 7- auf die Oberflächen 10 und 11 Metall aufgebracht. Für dieses Metallisieren werden die Si-Oberflächen 10 und 11 durch einen Dipetch in Flußsäure von möglicherweise noch vorhandenem Oberflächenoxyd befreit und dann anschließend mit Metall beschichtet. Diese Beschichtung kann durch Aufdampfen oder Sputtern erfolgen. Bevorzugte Schichtfolgen sind als Haftschicht Cr (Chrom) oder Ti (Titan) (Schichtdicke 50 bis 100nm) und als lötfähige Schicht Ni (Nickel) oder Ni-V (Nickel-Vanadium) (mit ca. 7-10% Vanadium, Schichtdicke 0,25 bis 1µm). Als Schutzschicht beziehungsweise Schicht, die beim Lotprozeß als Flußmittel dient, ist Au (Gold) oder Ag (Silber) (Schichtdicke 20-100nm) vorgesehen. Ganz besonders vorteilhaft ist es, wenn die Oberflächen 10 und 11 des Wafersystems 7 beidseitig simultan mit den gleichen Metallen besputtert werden. In einer ersten Station wird Cr (Chrom) durch Sputtern aufgebracht und anschließend -in einer nächsten Station einer Durchlaufsputteranlage mit Vakuum- Ni-V (Nickel-Vanadium) durch Sputtern aufgebracht. In einer dritten Station wird bevorzugt Ag (Silber) durch Sputtern aufgebracht. Insgesamt kann dieses Aufbringen vollautomatisch in relativ kurzer Taktzeit mit hoher Präzision (hoher Gleichmäßigkeit) ablaufen. Das erfindungsgemäße Verfahren, bei dem gleichzeitig beide Seiten beschichtet werden, hat gegenüber den bekannten Verfahren, bei denen die eine Waferseite und dann erst die andere Waferseite beschichtet werden, erhebliche Vorteile, da zum Beispiel gegenüber einem Bedampfen vermieden wird, daß eine fertig beschichtete Oberfläche beim Beschichten der anderen Oberfläche mit Metallen kontaminiert wird und dadurch die Lötfähigkeit in Frage gestellt ist. Auch wird verhindert, daß beim Beschichten der ersten Oberfläche bereits die zweite, noch nicht beschichtete Oberfläche kontaminiert wird, so daß dann dort später die Metallschicht nicht mehr gut haftet. Das gleichzeitige Beschichten beider Seiten hat auch den Vorteil, daß kurz nach dem Überätzen mit Flußsäure beide Seiten behandelt werden, so daß keine Zeit vergeht, die bereits wieder zu einer Oxydation führen kann, wenn zum Beispiel die eine Seite behandelt und erst später die andere Seite beschichtet wird. Es ist nicht erforderlich, die aufgebrachten Metallschichtfolgen beim Gegenstand der Erfindung mit einem anschließenden Temperaturbehandlungsschritt (zum Beispiel 450°C-500°C) zu behandeln, da die durch Schleifen vorbereiteten Si-Oberflächen 10 und 11 sehr gut für das Aufbringen dieser Metallisierung geeignet sind.

Im letzten Verfahrensschritt werden die einzelnen Chips 8 mittels Sägeschnitten 13 vereinzelt. Die durch die Sageschnitte 13 gebildeten Trennfugen liegen derart innerhalb der durch das Passivieren gefüllten Gräben 9, daß sie beide Wafer 1 und 2 vollständig durchsetzen und Passivierungsmaterial 14 beidseitig der Trennfuge zum Abdecken der Seitenflanken der Chips 8 (Abdecken der pn-übergänge) stehen bleibt.

Nach dem Heraustrennen der einzelnen Halbleiterelemente (Chips 8) liegen Halbleiterbauelemente vor, die sofort elektrisch vorgemessen und somit geprüft werden können, ohne daß sie vorher montiert oder in ein Gehäuse eingebracht beziehungsweise ummantelt werden müssen.

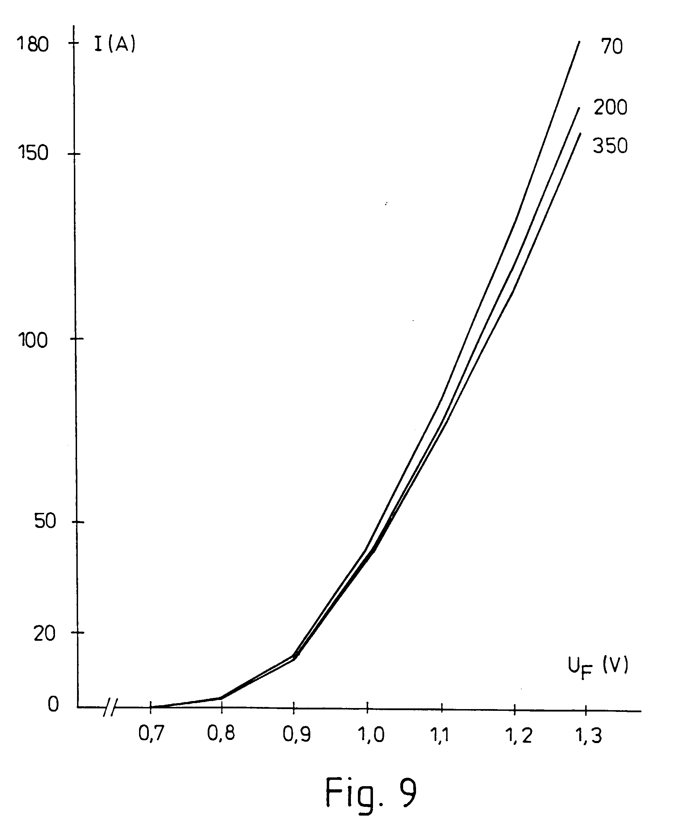

Die verhältnismäßig große Dicke des Wafers 2 gemaß dem erfindungsgemäßen Herstellungsverfahren kann vorteilhaft für einen Wärmepuffer bei Leistungsdioden im Impulsbetrieb genutzt werden. Die dabei in Kauf zu nehmende Erhöhung der Flußspannung U_{F} kann -gemäß Figur 9- ohne weiteres akzeptiert werden. Die Figur zeigt den Verlauf der Flußspannung U_{F} als Funktion des Stroms I. Zugrundegelegt wird ein Bauelement mit einer Chipfläche von 14,2 mm², einer n⁻ -Dicke von 75µm und einer n⁺-Dicke von 175µm. Angegeben werden drei Kurvenverläufe mit den Parametern der p⁺-Dicke von 70µm, 200µm und 350µm. Es ist erkennbar, daß eine Erhöhung der p⁺-Dicke von 200µm auf 350µm die Flußspannung U_{F} bei I = 100A um etwa nur 12mV erhöht.

Das erfindungsgemäße Verfahren läßt sich selbstverständlich sinngemäß auch auf andere Ausgangs-Si-Wafer übertragen, zum Beispiel auf großere schwach dotierte Zonen im n-Wafer oder zur Herstellung von Zener-Leistungsdioden, wobei der n/n⁺-Wafer durch einen geeignet hoch homogen dotierten n-Wafer ersetzt wird.

Es kann vorteilhaft sein, keine Vereinzelung der einzelnen Chips vorzunehmen, sondern die Nahordnung auf dem Wafersystem 7 teilweise zu erhalten. Dies kann insbesondere von Vorteil sein, wenn es sich bei den Chips um Zener-Dioden für Gleichrichter eines KFZ-Drehstromgenerators handelt. Bei Load dump-Belastung eines KFZ-Gleichrichters sind mindestens zwei Zener-Dioden in Rückwärtsrichtung parallel zueinander geschaltet. Um die überlastung einer Zener-Diode zu vermeiden, muß die Differenz der Zenerspannung der beiden Dioden minimal sein. Zur Minimierung dieser Differenz erfolgt üblicherweise ein Sortieren der einzelnen Chips in Spannungsklassen und dann eine klassenweise Verwendung im Gleichrichter. Dieser Aufwand wird eingespart, wenn erfindungsgemäß benachbarte Chips 8 nach dem Sägen auf der Sägefolie bleiben und von da -nach einem elektrischen Meßschritt- direkt in den Gleichrichter eingebaut werden. Die Nahordnung auf dem Wafersystem 7 bleibt also dann im Hinblick auf den Einsatz im Gleichrichter erhalten. Da erfindungsgemäß die SFB-Methode eingesetzt wird und insofern lediglich eine Streuung in der n-Mittelzone übrig bleibt, weichen die Zenerspannungen der erfindungsgemäß hergestellten Zenerdioden benachbarter Chips 8 nur minimal voneinander ab.

Durch das SFB-Verfahren besteht eine sehr gute Einflußnahmemöglichkeit auf die Trägerlebensdauer, also auf die Ladungsträgerrekombination und damit auf die Schaltzeit der Dioden sowie auf den sehr exakt zu definierenden pn-Übergang.

## Patentansprüche

1. Verfahren zur Herstellung von Halbleiterbauelementen, insbesondere Dioden, mit den in nachfolgender Reihenfolge durchzuführenden Schritten:
- Verbinden zweier Halbleiterkörper (Wafer 1, 2) unterschiedlichen Leitungstyps (p, n) und geeigneter Dotierungen (3, 4), insbesondere zur Herstellung hoch sperrender oder Zenor-Dioden, nach dem Silicium-Verschmelzungs-Verbindungsverfahren (SFB),
- Separieren einer Vielzahl von Halbleiterelementen (Chips 8) durch Einsägen von Gräben (9), deren Tiefe zumindest bis zu den pn-Übergängen reicht,
- Überätzen der seitlich durch die Gräben (9) freigelegten pn-Übergänge,
- Aufbringen einer Passivierung (12), und Auffüllen (12, 14) der Gräben (9)
- mechanisches Abtragen der Oberfläche (10) bis das Siliziummaterial wieder freigelegt ist,
- Metallisieren der Oberflächen (10, 11) der Halbleiterkörper und
- Heraustrennen (13) der Halbleiterelemente (8) aus den Halbleiterkörpern.

2. Verfahren nach Anspruch 1, **dadurch gekennzeichnet,** daß das Silicium-Verschmelzungs-Verbindungsverfahren bei Temperaturen über 1000°C für mehr als eine Stunde, insbesondere bei 1080°C für zwei Stunden unter Stickstottatmosphäre, durchgeführt wird.

3. Verfahren nach einem der vorhergehenden Ansprüche, **dadurch gekennzeichnet,** daß die Tiefe der Sägeschnitte derart gewählt wird, daß der Wafer (1) vollständig und der andere Wafer (2) teilweise zersägt beziehungsweise eingesägt wird.

4. Verfahren nach einem der vorhergehenden Ansprüche, **dadurch gekennzeichnet,** daß die Sägeschnitte zum Abtragen der durch den Sägevorgang erfolgten Beschädidungen der PN-Übergänge durchnaßchemische Ätzung, insbesondere mit heißer Kalilauge, erweitert werden.

5. Verfahren nach einem der vorhergehenden Ansprüche, **dadurch gekennzeichnet,** daß das Passivieren mit in die Gräben (9) eingebrachtem Polyesterimid-Lack oder dergleichen erfolgt.

6. Verfahren nach einem der vorhergehenden Ansprüche, **dadurch gekennzeichnet,** daß der Polyesterimid-Lack zur Durchführung des Passivierungsvorgangs mit Wasser verdünnt wird.

7. Verfahren nach Anspruch 6, **dadurch gekennzeichnet,** daß der angesägte Wafer auf eine erhöhte Temperatur -vorzugsweise 70°C- gebracht wird, bevor der Polyesterimid-Lack aufgebracht wird.

8. Verfahren nach einem der vorhergehenden Ansprüche, **dadurch gekennzeichnet,** daß das Passivieren durch thermisches Oxydieren, insbesondere bei über 1000°C und anschließendem Einbringen von Lack, insbesondere polyesterimid-Lack oder dergleichen, erfolgt.

9. Verfahren nach einem der vorhergehenden Ansprüche, **dadurch gekennzeichnet,** daß das Passivieren durch Abscheidung einer Substanz, insbesondere mittels eines pyrolytischen Abscheideverfahrens, vorzugsweise durch Abscheiden von Silicium-Nitrid, erfolgt.

10. Verfahren nach einem der vorhergehenden Ansprüche, **dadurch gekennzeichnet,** daß das Passivieren mit in die Gräben (9) eingebrachtem Polyimid-Lack erfolgt.

11. Verfahren nach einem der vorhergehenden Ansprüche, **dadurch gekennzeichnet,** daß für das Metallisieren Metall auf die Oberflächen (10,11) aufgedampft und/oder aufgesputtert wird.

12. Verfahren nach einem der vorhergehenden Ansprüche, **dadurch gekennzeichnet,** daß die Oberflächen (10,11) beider Wafer (1,2) gleichzeitig metallisiert werden.

13. Verfahren nach einem der vorhergehenden Ansprüche, **dadurch gekennzeichnet,** daß die Oberflächen (10,11) beider Wafer (1,2) gleichzeitig metallisiert werden mit Haftschichten aus Chrom oder Titan, lötfähigen Schichten aus Nickel oder Nickel-Vanadium und Deckschichten aus Gold oder Silber.

14. Verfahren nach einem der vorhergehenden Ansprüche, **dadurch gekennzeichnet,** daß beim Heraustrennen der Chips (8) die Trennfugen innerhalb der durch passivieren gefüllten Gräben (9) derart ausgebildet werden, der sie beide Wafer (1,2) vollständig durchsetzen und Passievierungsmaterial (14) zum Abdecken der Seitenflanken der Halbleiterelemente (Chips 8) stehen bleibt.

15. Verfahren nach Anspruch 14, **dadurch gekennzeichnet,** daß die Trennfugen durch Durchsägen des Wafersystems (7) erzeugt werden.

## Claims

1. Process for the production of semiconductor components, in particular diodes, having the steps to be carried out in the following sequence:
- bonding of two semiconductor bodies (wafers 1, 2) of different conduction type (p, n) and suitable dopings (3, 4), in particular for producing high-blocking or Zener diodes, according to the silicon fusion bonding (SFB) process,
- separation of a multiplicity of semiconductor elements (chips 8) by sawing in trenches (9) whose depth extends at least as far as the pn junctions,
- surface etching of the pn junctions laterally exposed by the trenches (9),
- application of a passivation (12) and filling (12, 14) of the trenches (9),
- mechanical removal of the surface (10) until the silicon material is again exposed,
- metallization of the surfaces (10, 11) of the semiconductor bodies, and
- separation (13) of the semiconductor elements (8) from the semiconductor bodies.

2. Process according to Claim 1, characterized in that the silicon fusion bonding process is carried out at temperatures of above 1000°C for more than one hour, in particular at 1080°C for two hours under nitrogen atmosphere.

3. Process according to one of the preceding claims, characterized in that the depth of the saw cuts is chosen in such a way that wafer (1) is fully sawed through and the other wafer (2) is partially sawed into.

4. Process according to one of the preceding claims, characterized in that, in order to remove the damage to the pn junctions which results from the sawing process, the saw cuts are widened by wet chemical etching, in particular with hot potassium hydroxide solution.

5. Process according to one of the preceding claims, characterized in that the passivation is carried out with polyester imide coating or the like introduced into the trenches (9).

6. Process according to one of the preceding claims, characterized in that the polyester imide coating is thinned with water for carrying out the passivation process.

7. Process according to Claim 6, characterized in that the sawed wafer is heated to an elevated temperature (preferably 70°C) before the polyester imide coating is applied.

8. Process according to one of the preceding claims, characterized in that the passivation is carried out by thermal oxidation, in particular at above 1000°C, and with subsequent introduction of a coating, in particular a polyester imide coating or the like.

9. Process according to one of the preceding claims, characterized in that the passivation is carried out by deposition of a substance, in particular by means of a pyrolytic deposition process, preferably by depositing silicon nitride.

10. Process according to one of the preceding claims, characterized in that the passivation is carried out using a polyimide coating introduced into the trenches (9).

11. Process according to one of the preceding claims, characterized in that metal is vapour deposited and/or sputtered on to the surfaces (10, 11) for metallization.

12. Process according to one of the preceding claims, characterized in that the surfaces (10, 11) of both wafers (1, 2) are metallized simultaneously.

13. Process according to one of the preceding claims, characterized in that the surfaces (10, 11) of both wafers (1, 2) are simultaneously metallized with adhesive layers of chromium or titanium, solderable layers of nickel or nickel/vanadium and cover layers of gold or silver.

14. Process according to one of the preceding claims, characterized in that, when the chips (8) are separated, the divisions within the trenches (9) filled with passivation are designed in such a way that they fully penetrate both wafers (1, 2) and passivation material (14) remains for covering the sides of the semiconductor elements (chips 8).

15. Process according to Claim 14, characterized in that the divisions are produced by sawing through the wafer system (7).

## Revendications

1. Procédé de fabrication de composants semi-conducteurs, notamment de diodes selon les étapes exécutées dans l'ordre suivant :
- on relie deux semi-conducteurs à plaquettes (1, 2) à types de conduction différents (p, n) et dopage approprié (3, 4) notamment pour réaliser des diodes à forte tension de blocage ou diodes Zener selon le procédé de combinaison par fusion de silicium (procédé SFB),
- en séparant un grand nombre de composants semi-conducteurs (chips 8) en entaillant des sillons (9) dont la profondeur arrive au moins jusqu'aux jonctions pn,
- on corrode de manière excessive les jonctions pn dégagées latéralement par les sillons (9),
- on applique une couche de passivation (12) et on remplit (12, 14) les sillons (9),
- on enlève mécaniquement la surface (10) jusqu'à ce que le silicium soit de nouveau dégagé,
- on métallise les surfaces (10, 11) des corps semi-conducteurs et,
- on sépare (13) les composants semi-conducteurs (8) des corps semi-conducteurs.

2. Procédé selon la revendication 1, caractérisé en ce que le procédé de combinaison par fusion de silicium est effectué à des températures supérieures à 1 000°C pendant plus d'une heure, notamment à 1 080°C pendant deux heures et sous une atmosphère d'azote.

3. Procédé selon l'une des revendications précédentes, caractérisé en ce que la profondeur des traits de scie est choisie pour que la plaquette (1) soit sciée complètement et que l'autre plaquette (2) soit sciée partiellement ou soit amorcée.

4. Procédé selon l'une des revendications précédentes, caractérisé en ce que les traits de scie sont élargis par enlèvement des parties endommagées des jonctions pn par le sciage, en procédant à une corrosion chimique par voie humide, notamment avec une lessive chaude de potasse.

5. Procédé selon l'une des revendications précédentes, caractérisé en ce que la passivation se fait avec un verni de polyesterimide ou produits analogues mis dans les sillons (9).

6. Procédé selon l'une des revendications précédentes, caractérisé en ce que le verni de polyesterimide est dilué avec de l'eau pour effectuer l'opération de passivation.

7. Procédé selon la revendication 6, caractérisé en ce que la plaquette amorcée par sciage est mise à une température élevée de préférence à 70°C avant de recevoir le verni de polyesterimide.

8. Procédé selon l'une des revendications précédentes, caractérisé en ce que la passivation se fait par oxydation thermique, notamment à une température supérieure à 1000°C puis, introduction de verni, notamment de verni de polyesterimide ou analogue.

9. Procédé selon l'une des revendications précédentes, caractérisé en ce que la passivation se fait par dépôt d'une substance notamment par un procédé de dépôt pyrolytique de préférence par dépôt de nitrure de silicium.

10. Procédé selon l'une des revendications précédentes, caractérisé en ce que la passivation se fait avec un verni de polyimide placé dans les sillons (9).

11. Procédé selon l'une des revendications précédentes, caractérisé en ce que pour la métallisation on dépose un métal par dépôt à la vapeur et/ou par crépitement sur les surfaces (10, 11).

12. Procédé selon l'une des revendications précédentes, caractérisé en ce qu'on métallise simultanément les surfaces (10, 11) des deux plaquettes (1, 2).

13. Procédé selon l'une des revendications précédentes, caractérisé en ce qu'on métallise simultanément les surfaces (10, 11) des deux plaquettes (1, 2) avec des couches d'accrochage en chrome ou titane, avec des couches de soudage en nickel ou Nickel-Vanadium et des couches de recouvrement en or ou argent.

14. Procédé selon l'une des revendications précédentes, caractérisé en ce qu'en séparant les chips (8) on réalise les joints dans les sillons (9) remplis d'agent de passivation de façon que les deux plaquettes (1, 2) soient traversées complètement et que l'agent de passivation continue à recouvrir les flancs latéraux des composants semi-conducteurs (chips 8).

15. Procédé selon la revendication 14, caractérisé en ce qu'on réalise les joints séparés par sciage du système de plaquettes (7).
